# EUROPEAN PATENT APPLICATION

(11) **EP 3 843 125 A1**
(43) Date of publication of application: **30.06.2021**
(21) Application number: 19851325.1
(22) Date of filing: 19.07.2019
(51) Int. Cl.: H01L 21/205, C23C 16/455

(54) **VAPOR-PHASE GROWTH DEVICE**

(30) Priority: 24.08.2018 JP 2018157826
(71) Applicant: NuFlare Technology, Inc., Yokohama-shi, Kanagawa 235-8522 (JP)
(72) Inventor: DAIGO, Yoshiaki, Yokohama-shi, Kanagawa 235-8522 (JP); YAJIMA, Masayoshi, Yokohama-shi, Kanagawa 235-8522 (JP); SUZUKI, Kunihiko, Yokohama-shi, Kanagawa 235-8522 (JP); ISHIGURO, Akio, Yokohama-shi, Kanagawa 235-8522 (JP)
(74) Representative: Hoffmann Eitle
(86) International application number: PCT/JP2019/028426
(87) International publication number: WO 2020/039809

(57) **Abstract**

According to an embodiment, provided is a vapor phase growth apparatus including: a reactor; a first gas chamber provided above the reactor, a first process gas being introduced into the first gas chamber; and a plurality of first gas flow paths supplying the first process gas from the first gas chamber to the reactor, in which at least one of the plurality of gas flow paths has a first region and a second region located between the first region and the reactor, the first region has a first opening cross-sectional area in a plane perpendicular to a direction of a flow of the first process gas and a first length in the direction, the second region has a second opening cross-sectional area in the plane perpendicular to the direction and a second length in the direction, the first opening cross-sectional area is smaller than the second opening cross-sectional area, and the first length is equal to or less than the second length.

## Description

### TECHNICAL FIELD

The present invention relates to a vapor phase growth apparatus that supplies gas to a substrate to form a film.

### BACKGROUND ART

As a method for forming a high-quality semiconductor film, there is an epitaxial growth technique for forming a single crystal film by vapor phase growth on a surface of a substrate. In a vapor phase growth apparatus using an epitaxial growth technique, a substrate is mounted on a holder in a reactor held at a normal pressure or a reduced pressure.

Then, while heating the substrate, the process gas containing a raw material of a film is supplied from a gas chamber at an upper portion of the reactor to the reactor through the gas flow path. A thermal reaction of the process gas occurs on the surface of the substrate, and thus, an epitaxial single crystal film is formed on the surface of the substrate.

If the growth of the film in the reactor is repeated, reaction products may be deposited at the end of the gas flow path on the reactor side. As the amount of deposited reaction products increases, the opening cross-sectional area of the gas flow path changes. When the opening cross-sectional area of the gas flow path changes, the supply of the process gas to the reactor becomes unstable, and thus, the reproducibility of the characteristics of the film deteriorates. Therefore, it is preferable to suppress destabilization of the supply of the process gas to the reactor and improve the reproducibility of the characteristics of the film.

Patent Document 1 discloses a vapor phase growth apparatus that suppresses gas wraparound at the end of the gas flow path on the reactor side and suppresses the occurrence of particles due to the adhesion of deposits.

### CITATION LIST

### PATENT DOCUMENT

Patent Document 1: JP 2017-157678 A

### SUMMARY OF THE INVENTION

### PROBLEM TO BE SOLVED BY THE INVENTION

The invention is to provide a vapor phase growth apparatus capable of improving a reproducibility of characteristics of a film.

### MEANS FOR SOLVING PROBLEM

According to one aspect of the invention, there is provided a vapor phase growth apparatus including: a reactor; a first gas chamber provided above the reactor, a first process gas being introduced into the first gas chamber; and a plurality of first gas flow paths supplying the first process gas from the first gas chamber to the reactor, in which at least one of the plurality of first gas flow paths has a first region and a second region located between the first region and the reactor, the first region has a first opening cross-sectional area in a plane perpendicular to a direction of a flow of the first process gas and a first length in the direction, the second region has a second opening cross-sectional area in the plane perpendicular to the direction and a second length in the direction, the first opening cross-sectional area is smaller than the second opening cross-sectional area, and the first length is equal to or less than the second length.

### EFFECT OF THE INVENTION

According to the invention, it is possible to realize a vapor phase growth apparatus capable of improving a reproducibility of characteristics of a film.

### BRIEF DESCRIPTION OF DRAWINGS

Fig. 1 is a schematic cross-sectional view of a vapor phase growth apparatus according to the first embodiment;
Fig. 2 is a schematic cross-sectional view of a first gas flow path of the first embodiment;
Fig. 3 is a schematic cross-sectional view of a second gas flow path of the first embodiment;
Fig. 4 is an explanatory diagram of functions and effects of the vapor phase growth apparatus according to the first embodiment;
Fig. 5 is an explanatory diagram of the functions and effects of the vapor phase growth apparatus according to the first embodiment;
Fig. 6 is an explanatory diagram of the functions and effects of the vapor phase growth apparatus according to the first embodiment;
Fig. 7 is an explanatory diagram of the functions and effects of the vapor phase growth apparatus according to the first embodiment;
Fig. 8 is a schematic cross-sectional view of a first gas flow path of a second embodiment; and
Fig. 9 is a schematic cross-sectional view of a vapor phase growth apparatus according to a third embodiment.

### EMBOIMENTS FOR CARRYING OUT THE INVENTION

Hereinafter, an embodiment of the invention will be described with reference to the drawings.

In this specification, in some cases, the same or similar members may be denoted by the same reference numerals.

In this specification, a direction of gravity in a state where a vapor phase growth apparatus is installed so that films can be formed is defined as "lower", and the opposite direction is defined as "upper". Therefore, "lower portion" denotes a position in the direction of gravity with respect to a reference, and "below" denotes the direction of gravity with respect to the reference. In addition, "upper portion" denotes a position opposite to the direction of gravity with respect to the reference, and "above" denotes a direction opposite to the direction of gravity with respect to the reference . In addition, a "vertical direction" is the direction of gravity.

In addition, in this specification, a "process gas" is a general term for gases used for forming a film and has a concept including, for example, a source gas, an assist gas, a dopant gas, a carrier gas, and a mixed gas thereof.

A conductance denotes easiness of flow of a fluid flowing through a flow path. For example, the conductance of a cylindrical flow path having a diameter of D and a length of L is proportional to D⁴/L. Hereinafter, D⁴/L will be referred to as a conductance coefficient. In addition, in this specification, it is assumed that there is no change in pressure between an inlet and an outlet of the flow path due to a change in shape of the flow path. In addition, in a viscous flow region, the conductance is proportional to an average pressure of the flow path, but in this specification, the conductance is omitted in calculation so as not to be complicated. By doing so, the conductance of the flow path can be treated as being proportional only to the conductance coefficient.

### (First Embodiment)

A vapor phase growth apparatus according to a first embodiment includes: a reactor; a first gas chamber provided above the reactor, a first process gas being introduced into the first gas chamber; and a plurality of first gas flow paths supplying the first process gas from the first gas chamber to the reactor, in which at least one of the plurality of first gas flow paths has a first region and a second region located between the first region and the reactor, the first region has a first opening cross-sectional area in a plane perpendicular to a direction of a flow of the first process gas and a first length in the direction, the second region has a second opening cross-sectional area in the plane perpendicular to the direction and a second length in the direction, the first opening cross-sectional area is smaller than the second opening cross-sectional area, and the first length is equal to or less than the second length.

Since the vapor phase growth apparatus according to the first embodiment has the above configuration, even in a case where the reaction products are deposited at the end of the first gas flow path on the reactor side, destabilization of the supply of the first process gas to the reactor can be suppressed. Therefore, according to the vapor phase growth apparatus according to the first embodiment, it is possible to improve a reproducibility of characteristics of the film.

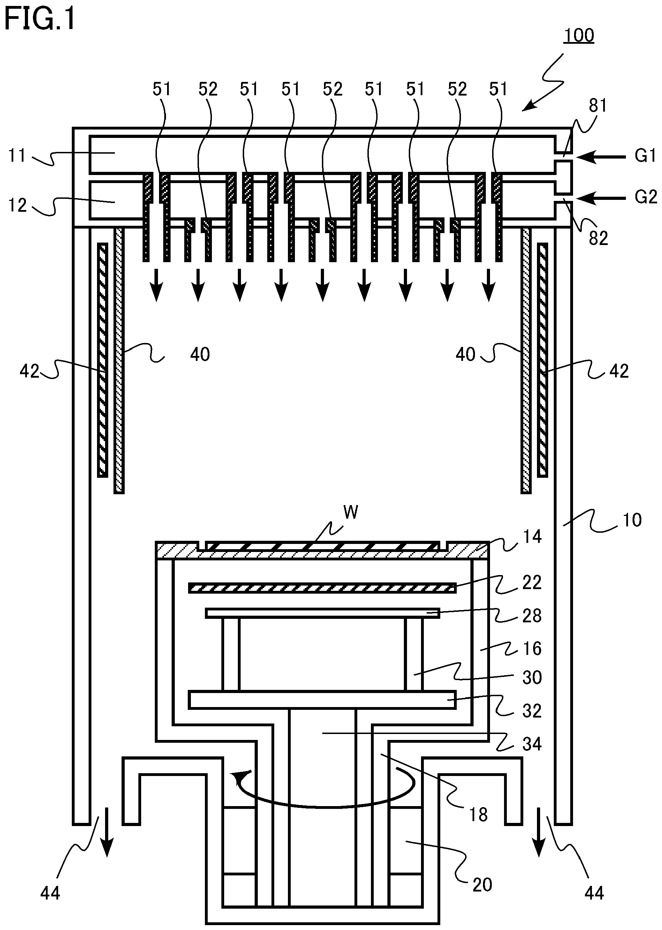

Fig. 1 is a schematic cross-sectional view of the vapor phase growth apparatus according to the first embodiment. The vapor phase growth apparatus 100 according to the first embodiment is, for example, a single wafer type epitaxial growth apparatus in which a single crystal SiC film is epitaxially grown on a single crystal SiC substrate.

The vapor phase growth apparatus 100 according to the first embodiment includes a reactor 10, a first gas chamber 11 (gas chamber), a second gas chamber 12, a plurality of first gas flow paths 51 (gas flow paths), a plurality of second gas flow paths 52, a first gas supply port 81, and a second gas supply port 82. The reactor 10 includes a susceptor 14 (holder), a rotating body 16, a rotating shaft 18, a rotation drive mechanism 20, a first heater 22, a reflector 28, support columns 30, a fixing base 32, a fixing shaft 34, a hood 40, a second heater 42, and a gas discharge port 44.

The reactor 10 is made of, for example, stainless steel. The reactor 10 has a cylindrical wall. A SiC film is formed on a wafer W in the reactor 10. The wafer W is an example of a substrate.

The susceptor 14 is provided in the reactor 10. The wafer W can be mounted on the susceptor 14. The susceptor 14 may be provided with an opening at the center. The susceptor 14 is an example of the holder.

The susceptor 14 is made of, for example, a highly heat-resistant material such as SiC, carbon, or carbon coated with SiC or TaC.

The susceptor 14 is fixed to the upper portion of the rotating body 16. The rotating body 16 is fixed to the rotating shaft 18. The susceptor 14 is indirectly fixed to the rotating shaft 18.

The rotating shaft 18 can be rotated by the rotation drive mechanism 20. By the rotation drive mechanism 20, the rotating shaft 18 is rotated, so that the susceptor 14 can be rotated. By rotating the susceptor 14, the wafer W mounted on the susceptor 14 can be rotated.

By the rotation drive mechanism 20, the wafer W can be rotated at a rotation speed of, for example, 300 rpm or more and 3000 rpm or less. The rotation drive mechanism 20 is configured with, for example, a motor and a bearing.

The first heater 22 is provided below the susceptor 14. The first heater 22 is provided in the rotating body 16. The first heater 22 heats the wafer W held by the susceptor 14 from below. The first heater 22 is, for example, a resistance heating heater. The first heater 22 has, for example, a disk shape with a comb-shaped pattern formed.

The reflector 28 is provided below the first heater 22. The first heater 22 is provided between the reflector 28 and the susceptor 14.

The reflector 28 reflects heat radiated downward from the first heater 22 to improve heating efficiency of the wafer W. In addition, the reflector 28 prevents members below the reflector 28 from being heated. The reflector 28 has, for example, a disk shape. The reflector 28 is made of, for example, a highly heat-resistant material such as carbon coated with SiC.

The reflector 28 is fixed to the fixing base 32 by, for example, the plurality of support columns 30. The fixing base 32 is supported by, for example, the fixing shaft 34.

A push up pin (not illustrated) is provided in the rotating body 16 in order to attach/detach the susceptor 14 to/from the rotating body 16. The push up pin penetrates, for example, the reflector 28 and the first heater 22.

The second heater 42 is provided between the hood 40 and the inner wall of the reactor 10. The second heater 42 heats the wafer W held by the susceptor 14 from above. By heating the wafer W with the second heater 42 in addition to the first heater 22, it is possible to heat the wafer W to the temperature required for the growth of the SiC film, for example, 1500°C or more. The second heater 42 is, for example, a resistance heating heater.

The hood 40 has, for example, a cylindrical shape. The hood 40 has a function of preventing a first process gas G1 and a second process gas G2 from coming into contact with the second heater 42. The hood 40 is made of, for example, a highly heat-resistant material such as carbon coated with SiC.

The gas discharge port 44 is provided at the bottom of the reactor 10. The gas discharge port 44 discharges surplus reaction products after reaction of the source gas on the surface of the wafer W and surplus process gases to the outside of the reactor 10. The gas discharge port 44 is connected to, for example, a vacuum pump (not illustrated).

In addition, the reactor 10 is provided with a wafer inlet/outlet and a gate valve (not illustrated). The wafer W can be loaded in reactor 10 and unloaded from the reactor 10 by the wafer inlet/outlet and the gate valve.

The first gas chamber 11 is provided above the reactor 10. The first gas chamber 11 is provided with the first gas supply port 81 for introducing the first process gas G1. The first gas chamber 11 is filled with the first process gas G1 introduced from the first gas supply port 81.

The first process gas G1 contains, for example, a source gas for silicon (Si) . The first process gas G1 is, for example, a mixed gas of the source gas for silicon, an assist gas that suppresses clustering of silicon, and a carrier gas.

The source gas for silicon is, for example, silane (SiH₄) . The assist gas is, for example, hydrogen chloride (HCl) . The carrier gas is, for example, argon gas or hydrogen gas.

The second gas chamber 12 is provided above the reactor 10. The second gas chamber 12 is provided between the reactor 10 and the first gas chamber 11. The second gas chamber 12 is provided with the second gas supply port 82 for introducing the second process gas G2. The second gas chamber 12 is filled with the second process gas G2 introduced from the second gas supply port 82.

The second process gas G2 contains, for example, a source gas for carbon. The second process gas G2 is, for example, a mixed gas of the source gas for carbon, a dopant gas for n-type impurity, and a carrier gas. The second process gas G2 is different from the first process gas G1.

The source gas for carbon is, for example, propane (C₃H₈) . The dopant gas for n-type impurity is, for example, nitrogen gas. The carrier gas is, for example, argon gas or hydrogen gas.

The plurality of first gas flow paths 51 are provided between the first gas chamber 11 and the reactor 10. The first gas flow paths 51 supply the first process gas G1 from the first gas chamber 11 to the reactor 10.

The plurality of second gas flow paths 52 are provided between the second gas chamber 12 and the reactor 10. The second gas flow paths 52 supply the second process gas G2 from the second gas chamber 12 to the reactor 10.

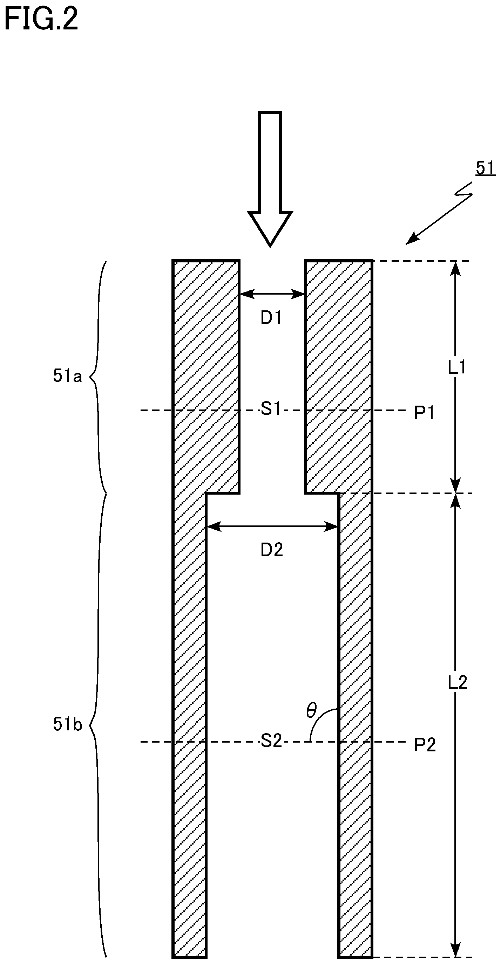

Fig. 2 is a schematic cross-sectional view of the first gas flow path of the first embodiment. The first gas flow path 51 has an upper region 51a (first region) and a lower region 51b (second region). The lower region 51b is located between the upper region 51a and the reactor 10.

The upper region 51a has a first opening cross-sectional area S1 in a plane (P1 in Fig. 2) perpendicular to a direction in which the process gas flows (white arrow in Fig. 2: first direction). In addition, the upper region 51a has a first length L1 in the direction in which the process gas flows (white arrow in Fig. 2).

The upper region 51a has, for example, a cylindrical shape having a length of L1. The opening cross section of the upper region 51a on the plane P1 has, for example, a circular shape having a diameter of D1.

The lower region 51b has a second opening cross-sectional area S2 in a plane (P2 in Fig. 2) perpendicular to the direction in which the process gas flows (white arrow in Fig. 2) . In addition, the lower region 51b has a second length L2 in the direction in which the process gas flows (white arrow in Fig. 2).

The lower region 51b has, for example, a cylindrical shape having a length of L2. The open cross section of the lower region 51b on a plane P2 has, for example, a circular shape having a diameter of D2.

An angle θ formed by an inner wall surface of the lower region 51b and the plane P2 is, for example, 80 degrees or more. The second length L2 is, for example, 5 mm or more.

The first opening cross-sectional area S1 is smaller than the second opening cross-sectional area S2. In addition, the first length L1 is equal to or less than the second length L2. That is, the second flowpath area (opening cross-sectional area) at the lower end of the lower region 51b is larger than the first flow path area (opening cross-sectional area) at the upper end of the upper region 51a, and a flow path area at the intermediate position (position of an intermediate height of the upper end and the lower end) of the gas flow path 51 is larger than the first flow path area at the upper end and is equal to or less than the second flow path area at the lower end.

The upper region 51a has a first conductance C1, and the lower region 51b has a second conductance C2. The first conductance C1 is smaller than the second conductance C2. A ratio of the first conductance C1 to the second conductance C2 (hereinafter, also referred to as a conductance ratio) is, for example, 1% or more and 40% or less.

The magnitude relationship between the first conductance C1 and the second conductance C2 matches with the magnitude relationship between the conductance coefficient of the upper region 51a and the conductance coefficient of the lower region 51b. In addition, the ratio of the first conductance C1 to the second conductance C2 (conductance ratio) matches with the ratio of the conductance coefficients, that is, ((D1)⁴/L1)/((D2)⁴/L2).

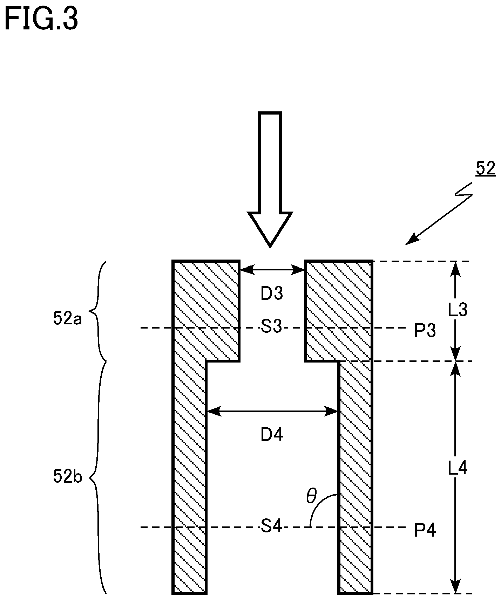

Fig. 3 is a schematic cross-sectional view of the second gas flow path of the first embodiment. The second gas flow path 52 has an upper region 52a (third region) and a lower region 52b (fourth region). The lower region 52b is located between the upper region 52a and the reactor 10.

The upper region 52a has a third opening cross-sectional area S3 in a plane (P3 in Fig. 3) perpendicular to a direction in which the process gas flows (white arrow in Fig. 3: second direction). In addition, the upper region 52a has a third length L3 in the direction in which the process gas flows (white arrow in Fig. 3).

The upper region 52a has, for example, a cylindrical shape having a length of L3. The open cross section of the upper region 52a on the plane P3 has, for example, a circular shape having a diameter of D3.

The lower region 52b has a fourth opening cross-sectional area S4 in a plane (P4 in Fig. 3) perpendicular to the direction in which the process gas flows (white arrow in Fig. 3) . In addition, the lower region 52b has a fourth length L4 in the direction in which the process gas flows (white arrow in Fig. 3).

The lower region 52b has, for example, a cylindrical shape having a length of L4. The open cross section of the lower region 52b on the plane P4 has, for example, a circular shape having a diameter of D4.

An angle θ formed by an inner wall surface of the lower region 52b and the plane P4 is, for example, 80 degrees or more. The fourth length L4 is, for example, 5 mm or more.

The third opening cross-sectional area S3 is smaller than the fourth opening cross-sectional area S4. In addition, the third length L3 is equal to or less than the fourth length L4.

The upper region 52a has a third conductance C3, and the lower region 52b has a fourth conductance C4. The third conductance C3 is smaller than the fourth conductance C4. A ratio of the third conductance C3 to the fourth conductance C4 (conductance ratio) is, for example, 1% or more and 40% or less.

The magnitude relationship between the third conductance C3 and the fourth conductance C4 matches with the magnitude relationship between the conductance coefficient of the upper region 52a and the conductance coefficient of the lower region 52b. In addition, the ratio of the third conductance C3 to the fourth conductance C4 (conductance ratio) matches with the ratio of the conductance coefficient, that is, ((D3)⁴/L3)/((D4)⁴/L4).

Next, the functions and effects of the vapor phase growth apparatus according to the first embodiment will be described.

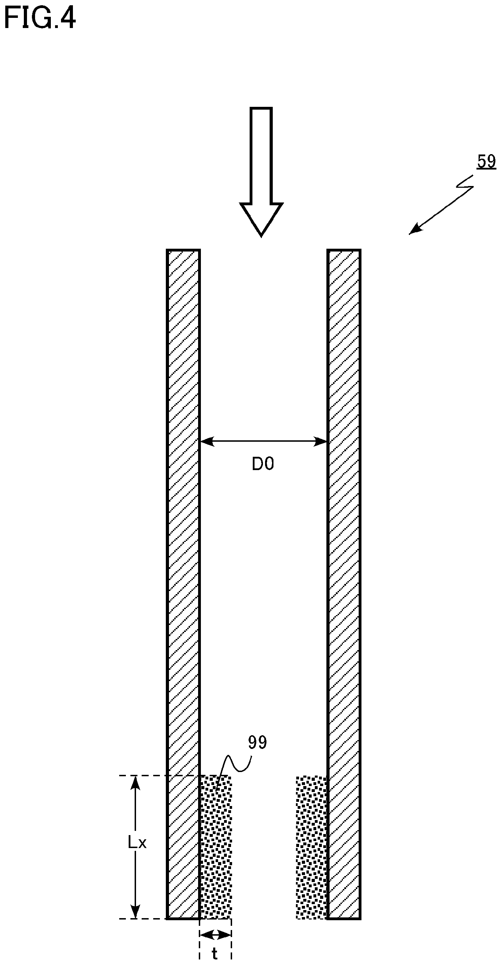

Fig. 4 is an explanatory diagram of the functions and effects of the vapor phase growth apparatus according to the first embodiment. Fig. 4 is a schematic cross-sectional view of the gas flow path 59 of Comparative Example. The gas flow path 59 of Comparative Example has a cylindrical shape. The opening cross section of the gas flow path 59 of Comparative Example has a circular shape having a diameter of D0.

For example, in a case where an SiC film is formed on the wafer W, the temperature at the end of the gas flow path 59 on the reactor 10 side rises due to radiant heat. As the temperature rises, the reaction products 99 of the process gas may be deposited at the end of the gas flow path 59 on the reactor 10 side. The reaction product 99 is assumed to have a thickness of t and a length of Lx. By repeating the formation of the SiC film, the thickness t of the deposit becomes thicker, and the length Lx becomes longer.

Due to the deposition of the reaction products 99, the effective diameter of the inner wall surface at the end of the gas flow path 59 on the reactor 10 side is reduced as small as (D0 - 2t) . Due to the reduction of the effective diameter of the inner wall surface, the opening cross-sectional area is also reduced, and the conductance of the gas flow path 59 is reduced. Therefore, it becomes difficult for the process gas to flow through the gas flow path 59.

Due to the change of the conductance of the gas flow path 59 with time, the flow velocity and flow rate of the process gas flowing through the gas flow path 59 change with time, and the reproducibility of the characteristics of the SiC film deteriorates. In particular, in a case where the deposition of the reaction products 99 on the plurality of gas flow paths 59 depends on the position of the gas flow paths 59, the reproducibility of the wafer in-plane uniformity of the characteristics of the SiC film also deteriorates. That is, the amount of change in conductance differs between the plurality of gas flowpaths 59, so that the balance of the process gas supplied into the reactor 10 is lost, and the reproducibility of the wafer in-plane uniformity of the SiC film deteriorates.

Due to the deposition of the reaction products 99, for example, the reproducibility of the average value of the film thickness or the carrier concentration of the SiC film deteriorates. In addition, for example, the reproducibility of the wafer in-plane uniformity of the film thickness or the carrier concentration of the SiC film deteriorates.

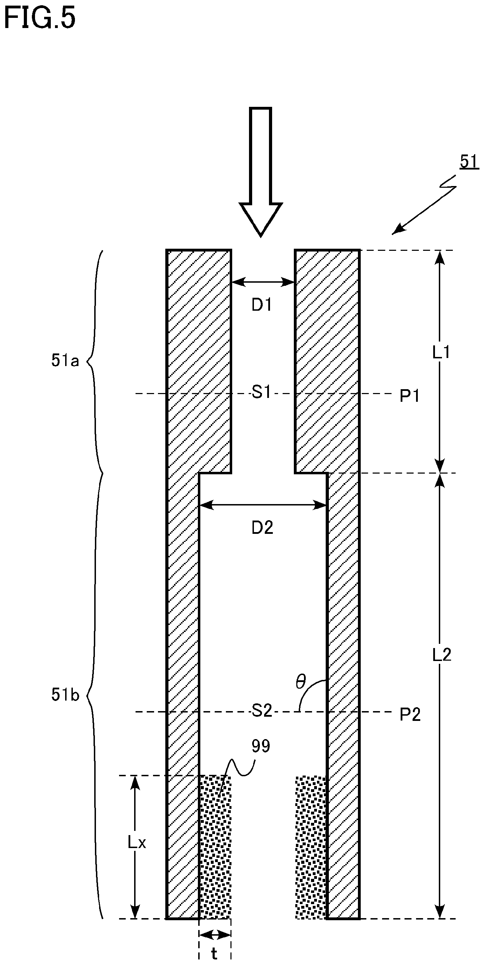

Fig. 5 is an explanatory diagram of the functions and effects of the vapor phase growth apparatus according to the first embodiment. Fig. 5 is a schematic cross-sectional view of the first gas flow path 51.

The first gas flow path 51 of the vapor phase growth apparatus according to the first embodiment has a two-stage structure of an upper region 51a having a small conductance and a lower region 51b having a large conductance. The lower region 51b having a large conductance is located on the reactor 10 side of the first gas flow path 51. By allowing the first opening cross-sectional area S1 to be smaller than the second opening cross-sectional area S2, the conductance of the first gas flow path 51 is allowed to be smaller than the conductance of the lower region 51b.

Even if the reaction products 99 are deposited at the end of the lower region 51b on the reactor 10 side and the conductance of the lower region 51b is decreased, the decrease in conductance of whole of the first gas flow path 51 is suppressed as compared with the case of Comparative Example. Therefore, the deterioration of the reproducibility of the characteristics of the SiC film is suppressed.

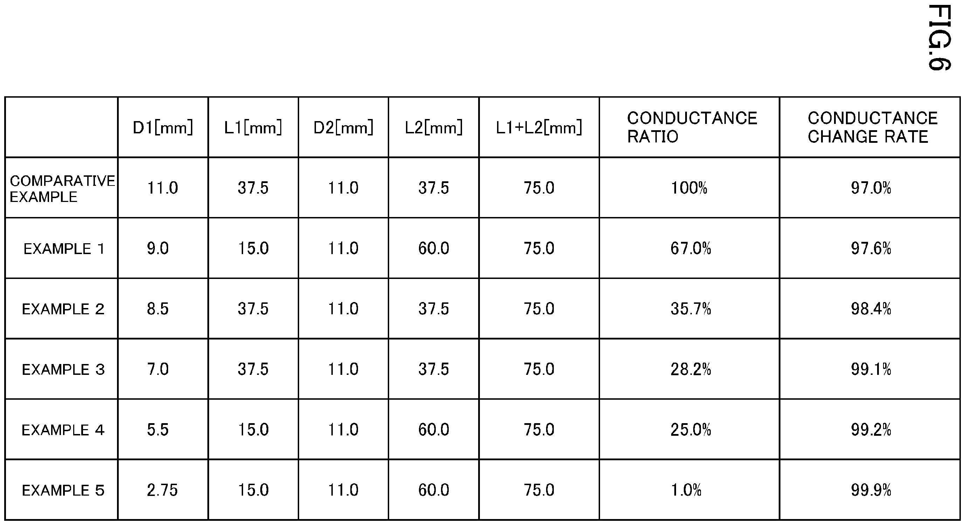

Fig. 6 is an explanatory diagram of the functions and effects of the vapor phase growth apparatus according to the first embodiment. Fig. 6 is a diagram illustrating calculation results of a conductance change rate in a case where the reaction products are deposited in the gas flow paths of Comparative Examples and Examples 1 to 5.

Examples 1 to 5 are premised on the shape of the first gas flow path 51 illustrated in Fig. 2. In addition, the deposited reaction products 99 were assumed to have a thickness of t = 0.5 mm and a length of Lx = 5 mm.

The conductance ratio is the ratio of the first conductance C1 to the second conductance C2, that is, the ratio of the conductance coefficient. In addition, the conductance change rate is a ratio of the conductance coefficient after the deposition to the conductance coefficient of whole of the first gas flow path 51 before the deposition of the reaction products 99. As the conductance change rate is closer to 100%, the decrease in conductance is smaller.

By adopting the structure of the example, the conductance change rate is closer to 100% than that of Comparative Example. Therefore, the change in conductance associated with the deposition of the reaction products 99 is suppressed. Accordingly, the deterioration of the reproducibility of the characteristics of the SiC film is suppressed.

The conductance ratio is preferably 1% or more and 40% or less, and more preferably 20% or more and 30% or less. If the conductance ratio falls below the above-mentioned range, there is a concern that the gas flow rate may be decreased. If the conductance ratio exceeds the above-mentioned range, there is a concern that the effect of suppressing the change in conductance associated with the deposition of the reaction products 99 may be insufficient.

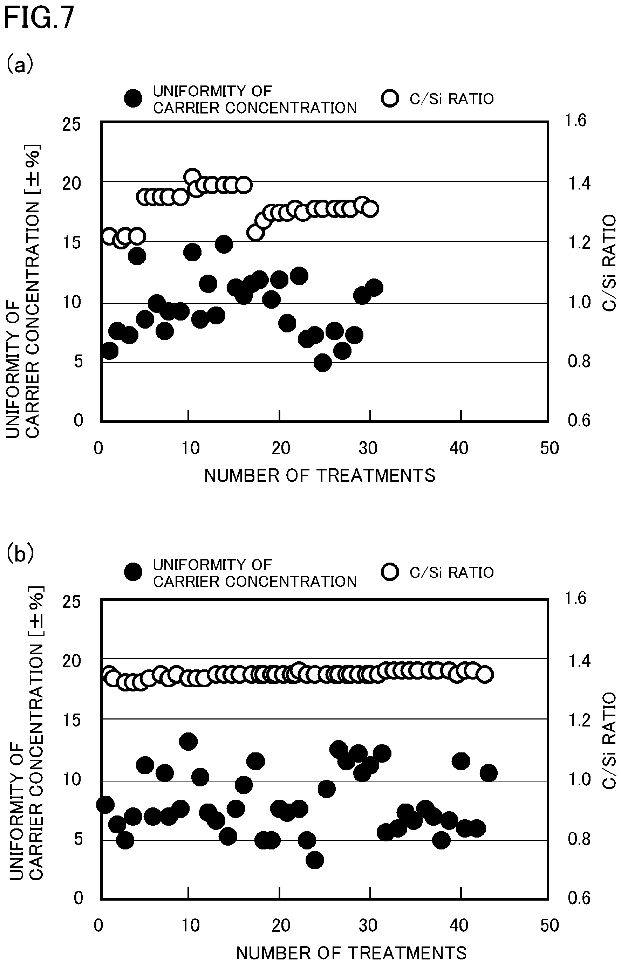

Fig. 7 is an explanatory diagram of the functions and effects of the vapor phase growth apparatus according to the first embodiment. Fig. 7 is a diagram illustrating a change in the characteristics of the SiC film with time in cases where the gas flow paths of Comparative Example and Example are used. Fig. 7(a) corresponds to the case of Comparative Example, and Fig. 7 (b) corresponds to the case of Example. In Example, the gas flow path corresponding to the fourth embodiment of Fig. 6 is used.

The horizontal axis indicates the number of treatments for forming the SiC film by using the vapor phase growth apparatus. The vertical axis indicates the wafer in-plane uniformity of the carrier concentration of the SiC film (carrier concentration uniformity). In addition, the vertical axis indicates an atomic ratio (C/Si ratio) of carbon contained in the second process gas G2 introduced into the second gas chamber 12 to silicon contained in the first process gas G1 introduced into the first gas chamber 11. During forming the SiC film, by adjusting the C/Si ratio, the wafer in-plane uniformity of the carrier concentration is controlled to be, for example, within 15%.

As illustrated in Fig. 7(a), in the case of Comparative Example, in order to maintain the wafer in-plane uniformity of the carrier concentration, it was necessary to change the C/Si ratio by 0.21 in the range. On the contrary, as illustrated in Fig. 7(b), in the case of the example, the wafer in-plane uniformity of the carrier concentration can be maintained only by changing the C/Si ratio by 0.03 in the range. From the above-described results, the reproducibility of the characteristics of the SiC film in the examples is clearly improved as compared with Comparative Example.

In the first gas flow path 51, an angle formed by an inner wall surface of the lower region 51b and the plane P2 is preferably 80 degrees or more, and more preferably 85 degrees or more. If the angle falls below the above-mentioned range, the inner wall surface of the lower region 51b is likely to be irradiated with radiant heat. Therefore, the temperature rise of the inner wall surface of the lower region 51b becomes large, and thus, there is a concern that the amount of the deposited reaction products 99 may increase.

In addition, by setting the first length L1 to the second length L2 or less, the occurrence of the deposition of the reaction products 99 on the inner wall surface of the upper region 51a is suppressed.

In the first gas flow path 51, the second length L2 is preferably 5 mm or more, and more preferably 10 mm or more. If the second length L2 falls below the above-mentioned range, there is a concern that the deposition of the reaction products 99 on the inner wall surface of the upper region 51a may occur.

As described above, according to the vapor phase growth apparatus according to the first embodiment, even in a case where the reaction products are deposited at the end of the gas flow path on the reactor side, destabilization of the supply of the process gas to the reactor can be suppressed. Therefore, according to the vapor phase growth apparatus according to the first embodiment, it is possible to improve a reproducibility of characteristics of a film.

### (Second Embodiment)

A vapor phase growth apparatus according to a second embodiment is different from the vapor phase growth apparatus according to the first embodiment in that the first region is a component that is separable from the second region. Hereinafter, a portion of the description of contents overlapping with the first embodiment will be omitted.

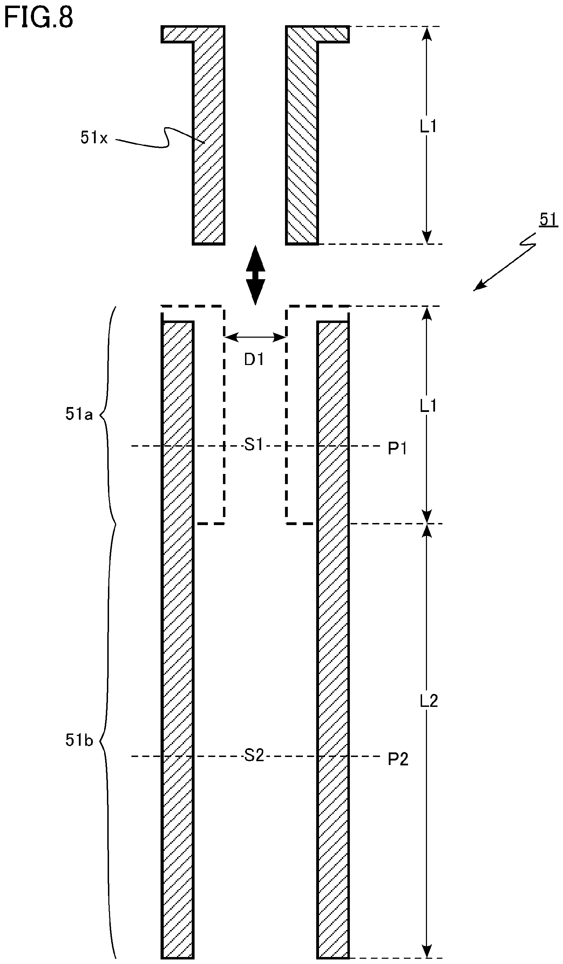

Fig. 8 is a schematic cross-sectional view of the first gas flow path of the second embodiment. The first gas flow path 51 has an upper region 51a and a lower region 51b. The first gas flow path 51 includes a component 51x.

The component 51x constitutes at least a portion of the upper region 51a. The component 51x is separable from the lower region 51b.

By forming the upper region 51a with the component 51x separable from the lower region 51b, the first opening cross-sectional area S1 and the first length L1 can be easily adjusted. Therefore, it becomes easy to improve a reproducibility of characteristics of a film.

According to the vapor phase growth apparatus according to the second embodiment, similarly to the vapor phase growth apparatus according to the first embodiment, even in a case where the reaction products are deposited at the end of the gas flow path on the reactor side, destabilization of the supply of the process gas to the reactor can be suppressed. Therefore, it is possible to improve a reproducibility of characteristics of a film. In addition, by using the component 51x, it becomes easy to improve the reproducibility of the characteristics of the film.

### (Third Embodiment)

A vapor phase growth apparatus according to a third embodiment is different from the vapor phase growth apparatus according to the first embodiment in that the vapor phase growth apparatus has one gas chamber. Hereinafter, a portion of the description of contents overlapping with the first embodiment will be omitted.

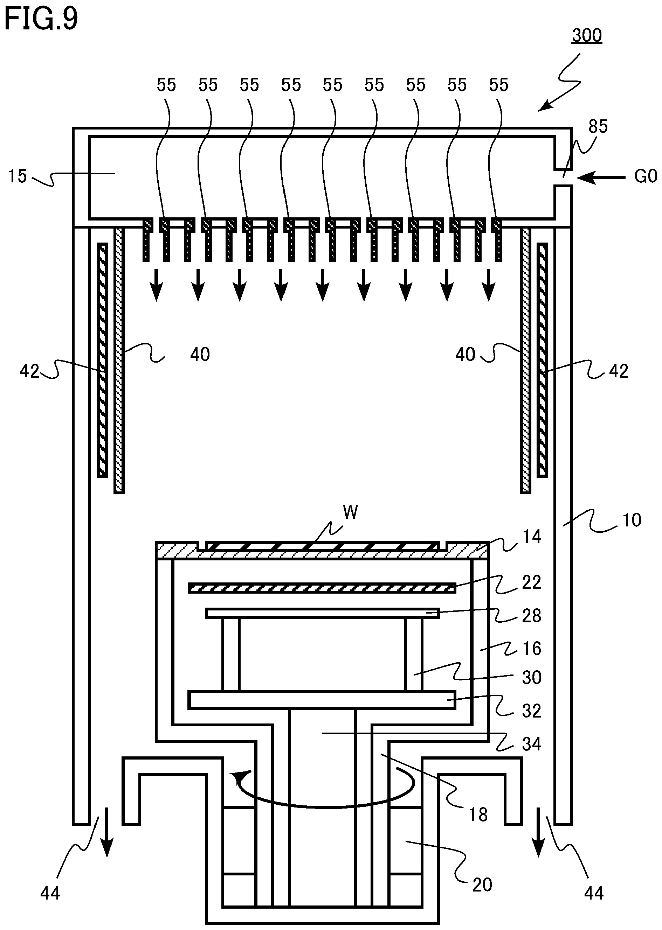

Fig. 9 is a schematic cross-sectional view of the vapor phase growth apparatus according to the third embodiment. A vapor phase growth apparatus 300 according to the third embodiment is, for example, a single wafer type epitaxial growth apparatus in which a single crystal SiC film is epitaxially grown on a single crystal SiC substrate.

The vapor phase growth apparatus 300 according to the third embodiment includes a reactor 10, a gas chamber 15 (first gas chamber), a plurality of gas flow paths 55 (first gas flow paths), a first gas supply port 81, and a second gas supply port 82. The reactor 10 includes a susceptor 14 (holder), a rotating body 16, a rotating shaft 18, a rotation drive mechanism 20, a first heater 22, a reflector 28, a support column 30, a fixing base 32, a fixing shaft 34, a hood 40, a second heater 42, and a gas discharge port 44.

The gas chamber 15 is provided above the reactor 10. The gas chamber 15 is provided with a gas supply port 85 for introducing a process gas G0 (first process gas) . The gas chamber 15 is filled with the process gas G0 introduced from the gas supply port 85.

The process gas G0 is, for example, a mixed gas containing a source gas for silicon (Si), a source gas for carbon (C), an dopant gas for n-type impurity, an assist gas that suppresses clustering of silicon, and a carrier gas . The source gas for silicon is, for example, silane (SiH₄) . The source gas for carbon is, for example, propane (C₃H₈) . The dopant gas for n-type impurity is, for example, nitrogen gas. The assist gas is, for example, hydrogen chloride (HCl) The carrier gas is, for example, argon gas or hydrogen gas.

The plurality of gas flow paths 55 are provided between the gas chamber 15 and the reactor 10. The gas flow paths 55 supply the process gas G0 from the gas chamber 15 to the reactor 10. The gas flow path 55 has, for example, the same configuration as the first gas flow path 51 of the first embodiment.

According to the vapor phase growth apparatus according to the third embodiment, similarly to the first vapor phase growth apparatus, even in a case where the reaction products are deposited at the end of the gas flow path on the reactor side, destabilization of the supply of the process gas to the reactor can be suppressed. Therefore, according to the vapor phase growth apparatus according to the third embodiment, it is possible to improve a reproducibility of characteristics of a film.

The embodiments of the invention have been described above with reference to specific examples. The above-described embodiments are merely given as examples and do not limit the invention. In addition, the components of the embodiments may be combined as appropriate.

In the embodiments, the case of forming a single crystal SiC film has been described as an example, but the invention can also be applied to formation of a polycrystalline or amorphous SiC film. In addition, the invention can also be applied to formation of films other than the SiC film.

In addition, in the embodiments, the wafer of single crystal SiC has been described as an example of the substrate, but the substrate is not limited to the wafer of single crystal SiC.

In addition, in the embodiments, nitrogen has been described as an example of the n-type impurity, but for example, phosphorus (P) can be applied as the n-type impurity. In addition, it is also possible to apply p-type impurities as impurities.

In addition, in the embodiments, a case where the gas flow path has a cylindrical shape has been described as an example, but the shape of the gas flow path is not limited to the cylindrical shape and may be other shapes such as a quadrangular prism. In addition, in the embodiments, a case where the opening cross section of the gas flow path has a circular shape has been described as an example, but the opening cross section of the gas flow path is not limited to a circle and may be other shapes such as an ellipse, a square, and a rectangle.

In the embodiments, the description of portions and the like that are not directly required for the description of the invention such as the apparatus configuration and the manufacturing method is omitted, but the required apparatus configuration, the manufacturing method, and the like can be appropriately selected and used. In addition, all vapor phase growth apparatuses, annular holders, and vapor phase growth methods that include the elements of the invention and can be appropriately changed in design by those skilled in the art are included in the scope of the invention. The scope of the invention is defined by the scope of the claims and the scope of the equivalents.

In addition, the gas flow path according to the invention has a remarkable effect in a case where the reaction products are deposited at the end of the gas flow path on the reactor side. In a case where the deposition of reaction products on a plurality of gas flow paths depends on the position of the gas flow path, the gas flow path of the invention may be used only for the gas flow path in which reaction products are likely to be deposited.

### EXPLANATIONS OF LETTERS OR NUMERALS

- 10: REACTOR
- 11: FIRST GAS CHAMBER (GAS CHAMBER)
- 12: SECOND GAS CHAMBER
- 15: GAS CHAMBER
- 14: SUSCEPTOR (HOLDER)
- 51: FIRST GAS FLOW PATH (GAS FLOW PATH)
- 51a: UPPER REGION (FIRST REGION)
- 51b: LOWER REGION (SECOND REGION)
- 51x: COMPONENT
- 52: SECOND GAS FLOW PATH
- 52a: UPPER REGION (THIRD REGION)
- 52b: LOWER REGION (FOURTH REGION)
- 100: VAPOR PHASE GROWTH APPARATUS
- 300: VAPOR PHASE GROWTH APPARATUS
- G0: PROCESS GAS (FIRST PROCESS GAS)
- G1: FIRST PROCESS GAS (PROCESS GAS)
- G2: SECOND PROCESS GAS
- W: WAFER (SUBSTRATE)
- L1: FIRST LENGTH
- L2: SECOND LENGTH
- S1: FIRST OPENING CROSS-SECTIONAL AREA
- S2: SECOND OPENING CROSS-SECTIONAL AREA

## Claims

1. A vapor phase growth apparatus comprising:
a reactor;
a first gas chamber provided above the reactor, a first process gas being introduced into the first gas chamber; and
a plurality of first gas flow paths supplying the first process gas from the first gas chamber to the reactor,
wherein at least one of the plurality of first gas flow paths has a first region and a second region located between the first region and the reactor, the first region has a first opening cross-sectional area in a plane perpendicular to a direction of a flow of the first process gas and a first length in the direction, the second region has a second opening cross-sectional area in the plane perpendicular to the direction and a second length in the direction, the first opening cross-sectional area is smaller than the second opening cross-sectional area, and the first length is equal to or less than the second length.

2. The vapor phase growth apparatus according to claim 1, wherein the first region is a component separable from the second region.

3. The vapor phase growth apparatus according to claim 1, wherein the first region has a first conductance, the second region has a second conductance, and a ratio of the first conductance to the second conductance is 1% or more and 40% or less.

4. The vapor phase growth apparatus according to claim 1, wherein an angle formed by an inner wall surface of the second region and the plane perpendicular to the direction is 80 degrees or more.

5. The vapor phase growth apparatus according to claim 1, wherein the second length is 5 mm or more.

6. The vapor phase growth apparatus according to claim 1, further comprising:
a second gas chamber provided between the reactor and the first gas chamber, a second process gas different from the first process gas being introduced into the second gas chamber; and
a plurality of second gas flow paths supplying the second process gas from the second gas chamber to the reactor,
wherein at least one of the plurality of second gas flow paths has a third region and a fourth region located between the third region and the reactor, the third region has a third opening cross-sectional area in a plane perpendicular to a second direction of a flow of the second process gas and a third length in the second direction, the fourth region has a fourth opening cross-sectional area in the plane perpendicular to the second direction and a fourth length in the second direction, the third opening cross-sectional area is smaller than the fourth opening cross-sectional area, and the third length is equal to or less than the fourth length.

7. The vapor phase growth apparatus according to claim 6, wherein the third region is a component separable from the fourth region.

8. The vapor phase growth apparatus according to claim 6, wherein the third region has a third conductance, the fourth region has a fourth conductance, and a ratio of the third conductance to the fourth conductance is 1% or more and 40% or less.

9. The vapor phase growth apparatus according to claim 6, wherein an angle formed by an inner wall surface of the fourth region and the plane perpendicular to the second direction is 80 degrees or more.

10. The vapor phase growth apparatus according to claim 6, wherein the second length is 5 mm or more, and the fourth length is 5 mm or more.

11. A vapor phase growth apparatus comprising:
a gas chamber provided above a reactor, a process gas being introduced into the gas chamber; and
a plurality of gas flow paths supplying the process gas from the gas chamber to the reactor,
wherein a second flow path area at a lower end of one of the gas flow paths is larger than a first flow path area at an upper end of the one of the gas flow paths, and a flow path area at an intermediate position between the upper end and the lower end of the one of the gas flow paths is larger than the first flow path area and is equal to or less than the second flow path area.

## Amended claims

### Amended claims under Art. 19.1 PCT

1. (Amended) A vapor phase growth apparatus comprising:
a reactor;
a first gas chamber provided above the reactor, a first process gas being introduced into the first gas chamber;
a plurality of first gas flow paths supplying the first process gas from the first gas chamber to the reactor;
a holder provided in the reactor, a substrate being capable of being mounted on the holder; and
a heater capable of heating the substrate to a temperature of 1500°C or more,
wherein at least one of the plurality of first gas flow paths has a first region and a second region located between the first region and the reactor, the first region has a first opening cross-sectional area in a plane perpendicular to a direction of a flow of the first process gas and a first length in the direction, the second region has a second opening cross-sectional area in the plane perpendicular to the direction and a second length in the direction, the first opening cross-sectional area is smaller than the second opening cross-sectional area, and the first length is equal to or less than the second length, and
wherein the first region has a first conductance, the second region has a second conductance, and a ratio of the first conductance to the second conductance is 1% or more and 40% or less.

2. The vapor phase growth apparatus according to claim 1, wherein the first region is a component separable from the second region.

3. (Deleted)

4. The vapor phase growth apparatus according to claim 1, wherein an angle formed by an inner wall surface of the second region and the plane perpendicular to the direction is 80 degrees or more.

5. The vapor phase growth apparatus according to claim 1, wherein the second length is 5 mm or more.

6. The vapor phase growth apparatus according to claim 1, further comprising:
a second gas chamber provided between the reactor and the first gas chamber, a second process gas different from the first process gas being introduced into the second gas chamber; and
a plurality of second gas flow paths supplying the second process gas from the second gas chamber to the reactor,
wherein at least one of the plurality of second gas flow paths has a third region and a fourth region located between the third region and the reactor, the third region has a third opening cross-sectional area in a plane perpendicular to a second direction of a flow of the second process gas and a third length in the second direction, the fourth region has a fourth opening cross-sectional area in the plane perpendicular to the second direction and a fourth length in the second direction, the third opening cross-sectional area is smaller than the fourth opening cross-sectional area, and the third length is equal to or less than the fourth length.

7. The vapor phase growth apparatus according to claim 6, wherein the third region is a component separable from the fourth region.

8. The vapor phase growth apparatus according to claim 6, wherein the third region has a third conductance, the fourth region has a fourth conductance, and a ratio of the third conductance to the fourth conductance is 1% or more and 40% or less.

9. The vapor phase growth apparatus according to claim 6, wherein an angle formed by an inner wall surface of the fourth region and the plane perpendicular to the second direction is 80 degrees or more.

10. The vapor phase growth apparatus according to claim 6, wherein the second length is 5 mm or more, and the fourth length is 5 mm or more.

11. (Amended) A vapor phase growth apparatus comprising:
a gas chamber provided above a reactor, a process gas being introduced into the gas chamber;
a plurality of gas flow paths supplying the process gas from the gas chamber to the reactor;
a holder provided in the reactor, a substrate being capable of being mounted on the holder; and
a heater capable of heating the substrate to a temperature of 1500°C or more,
wherein at least one of the plurality of gas flow paths has a first region including an upper end of the at least one of the plurality of gas flow paths and a second region located between the first region and the reactor, a second flow path area at a lower end of the at least one of the plurality of gas flow paths is larger than an a first flow path area at the upper end of the at least one of the plurality of gas flow paths, and a flow path area at an intermediate position between the upper end and the lower end of the at least one of the plurality of gas flow paths is larger than the first flow path area and is equal to or less than the second flow path area, and
wherein the first region has a first conductance, the second region has a second conductance, and a ratio of the first conductance to the second conductance is 1% or more and 40% or less.

12. (Added) A vapor phase growth method comprising:
mounting a substrate in a reactor;
heating the substrate to a temperature of 1500°C or more; and
introducing a process gas into the reactor from a gas chamber provided above the reactor through a plurality of gas flow paths,
wherein at least one of the plurality of gas flow paths has a first region having a first conductance and a second region being located between the first region and the reactor, the second region having a length larger than that of the first region, and the second region having a second conductance, and a ratio of the first conductance to the second conductance is 1% or more and 40% or less.
